# DEMANDE DE BREVET EUROPEEN

(11) **EP 4 167 294 A1**
(43) Date de publication de la demande: **19.04.2023**
(21) Numéro de dépôt: 22200891.4
(22) Date de dépôt: 11.10.2022
(51) Int. Cl.: H01L 29/76, H01L 21/336, H01L 29/423, H01L 29/40, H01L 29/06, B82Y 10/00

(54) **DISPOSITIF COMPRENANT DES ESPACEURS COMPORTANT UNE ZONE D AIR LOCALISÉE ET PROCÉDÉS DE FABRICATION ASSOCIÉS**

(30) Priorité: 14.10.2021 FR 2110869
(71) Demandeur: Commissariat à l'énergie atomique et aux énergies alternatives, 75015 Paris (FR)
(72) Inventeur: NEMOUCHI, Fabrice, 38054 GRENOBLE CEDEX 09 (FR); LE ROYER, Cyrille, 38054 GRENOBLE CEDEX 09 (FR); POSSEME, Nicolas, 38054 GRNEOBLE CEDEX 09 (FR)
(74) Mandataire: Cabinet Camus Lebkiri

(57) **Abrégé**

Un aspect de l'invention concerne un dispositif (DI) semi-conducteur réalisé sur un substrat comprenant au moins une région active (RA) et une région non-active (RN) entourant au moins partiellement la région active (RA), une pluralité d'empilements de grille (EG), une partie de chaque empilement de grille (EG) de la pluralité d'empilements de grille (EG) étant sur la région active (RA), chaque empilement de grille (EG) étant séparé des empilements de grille (EG) adjacents au moyen d'un espaceur (ES) par une distance égale à e, le dispositif (DI) étant tel que, pour chaque empilement de grille (EG) de la pluralité d'empilements de grille (EG), la partie d'empilement de grille (EG) située sur la région active (RA) a une hauteur h₂, la partie du même empilement de grille (EG) située sur la région non-active (RN) a une hauteur h₁ et en ce que h₂/e =a₂ et h₁/e = a₁ < aₗᵢₘ où a₂ est un rapport d'aspect tel que, lors de la croissance du matériau espaceur formant les espaceurs (ES), une zone d'air est dans ledit espaceur (ES), et a₁ est un rapport d'aspect tel que, lors de la croissance du matériau espaceur formant les espaceurs (ES), aucune zone d'air n'est dans ledit espaceur (ES).

## Description

### DOMAINE TECHNIQUE DE L'INVENTION

Le domaine technique de l'invention est celui des dispositifs semi-conducteurs, notamment pour les applications aux qubits de spin.

La présente invention concerne dispositif comprenant des espaceurs comportant une zone d'air et en particulier un dispositif dans lequel les zones d'air sont localisées. La présente invention concerne également deux procédés de fabrication permettant d'obtenir un tel dispositif.

### ARRIERE-PLAN TECHNOLOGIQUE DE L'INVENTION

Dans le domaine des dispositifs semi-conducteurs pour la réalisation de qubits de spin, il est connu d'utiliser une pluralité de grilles disposées les unes à la suite des autres de sorte à réaliser une pluralité de qubits de spins qu'il est ensuite possible de coupler entre eux en jouant sur les barrières de potentiel séparant deux qubits adjacents.

La distance qui sépare en général les qubits impose une densité importante au niveau des grilles (typiquement un pas inférieur à 100 nm) de sorte qu'il existe un fort couplage entre les différentes grilles, en particulier au niveau de la région active du dispositif (le canal), c'est-à-dire la région dans laquelle vont être formés les qubits de spin. C'est d'autant plus vrai que, pour des raisons de fabrication, les matériaux utilisés pour réaliser les espaceurs ne sont pas des matériaux à faible permittivité (low-k en anglais) ce qui tend à renforcer le couplage entre les grilles adjacentes.

Afin de diminuer le couplage, il est connu de réaliser des espaceurs comprenant une zone d'air. C'est par exemple ce que propose le document US 2015/00911089 A1 ou bien encore le document US 2014/0110798. Cependant, les procédés décrits dans ces documents sont relativement complexes à mettre en oeuvre et ne permettent pas de localiser la zone de vie de chaque espaceur, cette dernière étant alors présente sur toute la longueur dudit espaceur.

Il existe donc un besoin d'un procédé permettant de fabriquer facilement des espaceurs comprenant une zone d'air et qui permet en outre de localiser cette zone à une partie seulement de l'espaceur.

### RESUME DE L'INVENTION

L'invention offre une solution aux problèmes évoqués précédemment, en permettant d'obtenir facilement des zones d'air localisées en jouant sur l'aspect de forme entre la hauteur des empilements de grille et de la distance qui les sépare.

Pour cela, un premier aspect de l'invention concerne un dispositif semi-conducteur réalisé sur un substrat comprenant au moins une région active et une région non-active entourant au moins partiellement la région active, une pluralité d'empilements de grille, une partie de chaque empilement de grille de la pluralité d'empilements de grille étant sur la région active et une partie desdits empilement de grille étant sur la région non active, chaque empilement de grille étant séparé d'au moins un empilement de grille adjacent, de préférence de chaque empilement de grille adjacent, au moyen d'un espaceur par une distance e, le dispositif étant caractérisé en ce que, pour chaque empilement de grille de la pluralité d'empilements de grille, la partie d'empilement de grille située sur la région active a une hauteur h₂, la partie du même empilement de grille située sur la région non-active a une hauteur h₁ et en ce que h₂/e = a₂ et h₁/e = a₁ où a₂ est un rapport d'aspect tel que, lors de la croissance du matériau espaceur formant les espaceurs, une zone d'air est dans ledit espaceur, et a₁ est un rapport d'aspect tel que, lors de la croissance du matériau espaceur formant les espaceurs, aucune zone d'air n'est dans ledit espaceur.

Grâce à l'invention, il est possible d'obtenir des espaceurs comprenant des zones d'air localisées au niveau de la région active du dispositif. De plus, comme le montrera la partie consacrée à la fabrication d'un tel dispositif, la réalisation de zones d'air (ou airgap en anglais) localisées est grandement facilitée par l'utilisation astucieuse du rapport d'aspect entre hauteur des empilements de grille et distance séparant lesdits empilements. Ces zones de vide permettent notamment de limiter les couplages capacitifs entre grilles lors du fonctionnement électriques. Elles doivent être à l'intérieur de l'espaceur (couvertes, et non découvertes) pour ne pas conduire à l'inclusion de métal lors de la formation des contacts/électrodes métalliques

Outre les caractéristiques qui viennent d'être évoquées dans le paragraphe précédent, le dispositif selon un premier aspect de l'invention peut présenter une ou plusieurs caractéristiques complémentaires parmi les suivantes, considérées individuellement ou selon toutes les combinaisons techniquement possibles.

Dans un mode de réalisation, la surface de la région active est située dans un premier plan et la surface de la région non-active est situé dans un deuxième plan, le premier plan étant située à une hauteur inférieure à celle du deuxième plan, la différence de hauteur Δh entre le premier plan et le deuxième plan étant égale à la différence entre la hauteur h₂ des empilements de grille sur la région active et la hauteur h₁ des empilements de grille sur la région non-active.

Dans un mode de réalisation, les espaceurs sont formés par une couche de matériau espaceur ayant une épaisseur t supérieure ou égale 0.3xe, de préférence 0.4×e, voire 0.5×e.

Dans un mode de réalisation, le matériau espaceur est le nitrure de silicium.

Dans un mode de réalisation, le dispositif comprend une pluralité de régions actives.

Dans un mode de réalisation, a₂ ≥ 1.5 et a₁ ≤ 1.

Dans un mode de réalisation, la hauteur h₁ est comprise entre 30 et 50 nm, la hauteur h₂ est comprise entre 60 et 100 nm et/ou la distance e séparant deux empilements de grilles successifs est comprise entre 20 et 40 nm.

Un deuxième aspect de l'invention concerne un procédé de fabrication d'un dispositif semiconducteur à partir d'un substrat comportant au moins une région active et une région non-active entourant au moins partiellement la région active, la surface de la région active étant située dans un premier plan et la surface de la région non-active étant située dans un deuxième plan, le premier plan étant située à une hauteur inférieure à celle du deuxième plan, le procédé comprenant :
- une étape de formation d'une pluralité d'empilement de grille parallèle les uns aux autres, chaque empilement de grille étant séparé du ou des empilements de grille les plus proches par une distance e ;
- une étape de dépôt d'une couche d'un matériau espaceur de sorte à former un espaceur entre chaque empilement de grille ;
- une étape de dépôt d'une couche d'un matériau diélectrique ;
- une étape de polissage-mécanochimique de sorte que, à l'issue de cette étape, la partie des empilements de grille située sur la région active a une hauteur h₂ ;

la hauteur entre le premier plan et le deuxième plan étant égale Δh, la hauteur h₂, la différence de hauteur Δh et la distance e séparant deux empilements de grille étant choisis de sorte que h₂/e = a₂ et (h₂-Δh)/e = a₁ où a₂ est un rapport d'aspect tel que, lors de la croissance du matériau espaceur formant les espaceurs, une zone d'air se forme au sein dudit espaceur, et a₁ est un rapport d'aspect tel que, lors de la croissance du matériau espaceur formant les espaceurs, aucune zone d'air ne se forme au sein dudit espaceur.

Dans un mode de réalisation, l'étape de polissage mécanochimique comprend :
- une première sous-étape de polissage mécanochimique de sorte à niveler la couche de matériau diélectrique ;
- une deuxième sous-étape de polissage mécano-chimique de sorte que, à l'issue de cette sous-étape, la partie des empilements de grille située sur la région active a une hauteur h₂.

Un troisième aspect de l'invention concerne un procédé de fabrication d'un dispositif semiconducteur à partir d'un substrat comportant au moins une région active et une région non-active entourant au moins partiellement la région active, la surface de la région active étant située dans un premier plan et la surface de la région non-active étant située dans un deuxième plan, le premier plan étant située à une hauteur inférieure à celle du deuxième plan, le procédé comprenant :
- une étape de dépôt pleine plaque d'une couche d'empilement de grille ;
- une étape de polissage-mécanochimique de sorte que, à l'issue de cette étape, la couche d'empilement de grille située sur la région active a une épaisseur h2 ;
- une étape de formation, à partir de la couche d'empilement de grille, d'une pluralité d'empilements de grille parallèles les uns aux autres, chaque empilement de grille étant séparé du ou des empilements de grille les plus proches par une distance e ;
- une étape de dépôt d'une couche d'un matériau espaceur de sorte à former un espaceur entre chaque empilement de grille ;

la différence de hauteur entre le premier plan et le deuxième plan étant égale Δh, l'épaisseur h₂, la différence de hauteur Δh et la distance e séparant deux empilements de grille étant choisis de sorte que h₂/e = a₂ et (h₂-Δh )/e = a₁ où a₂ est un rapport d'aspect tel que, lors de la croissance du matériau espaceur formant les espaceurs, une zone d'air se forme au sein dudit espaceur, et a₁ est un rapport d'aspect tel que, lors de la croissance du matériau espaceur formant les espaceurs, aucune zone d'air ne se forme au sein dudit espaceur.

Outre les caractéristiques qui viennent d'être évoquées dans les paragraphes précédents, le procédé selon un deuxième ou un troisième aspect de l'invention peut présenter une ou plusieurs caractéristiques complémentaires parmi les suivantes, considérées individuellement ou selon toutes les combinaisons techniquement possibles.

Dans un mode de réalisation, le matériau espaceur est le nitrure de silicium.

Dans un mode de réalisation, une épaisseur t de matériau espaceur telle que t ≥ 0.3×e, de préférence t ≥ 0.4xe, voire t ≥ 0.5xe, est déposée lors de l'étape de dépôt d'une couche d'un matériau espaceur.

Dans un mode de réalisation, a₂ ≥ 1.5 et a₁ ≤ 1.

Dans un mode de réalisation, l'étape de dépôt du matériau espaceur est réalisé par un dépôt chimique en phase vapeur assisté par plasma (PECVD pour Plasma-Enhanced Chemical Vapor Déposition en anglais), un dépôt chimique en phase vapeur à basse pression (LPCVD pour Low-Pressure Chemical Vapor Déposition en anglais) ou un dépôt dépôt chimique en phase vapeur à pression sous-atmosphérique (SACVD pour Sub-Atmospheric Pressure Chemical Vapor Déposition en anglais).

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
Les [Fig. 1A] à [Fig. 1E] illustre un dispositif semiconducteur selon l'invention.
La [Fig. 2A] montre la formation d'une zone d'air dans l'espaceur lorsque le facteur de forme de la structure est suffisamment élevé.
La [Fig. 2B] montre l'absence de formation d'une zone d'air dans l'espaceur lorsque le facteur de forme de la structure n'est pas suffisamment élevé.
La [Fig. 3] montre une représentation graphique des aspects de formes permettant d'obtenir une zone d'air lors de la formation des espaceurs.
La [Fig. 4] montre un logigramme d'un procédé de fabrication selon un deuxième aspect de l'invention.
Les [Fig. 5] à [Fig. 9B] montrent de manière schématique les étapes d'un procédé de fabrication selon un deuxième aspect de l'invention.
La [Fig. 10] montre un logigramme d'un procédé de fabrication selon un troisième aspect de l'invention.
Les [Fig. 11A] à [Fig. 13B] montrent de manière schématique les étapes d'un procédé de fabrication selon un troisième aspect de l'invention.

### DESCRIPTION DETAILLEE

Les figures sont présentées à titre indicatif et nullement limitatif de l'invention.

### Dispositif semiconducteur à zones d'air localisées

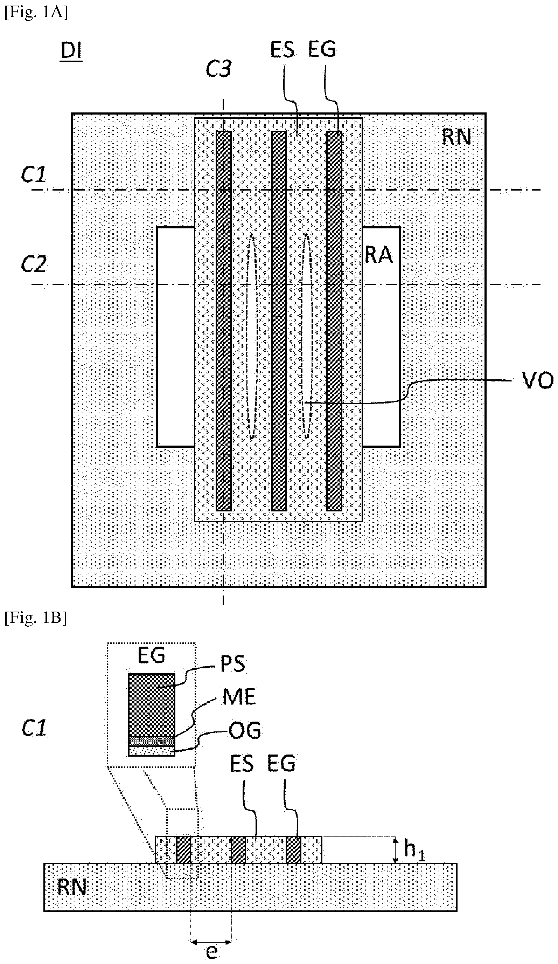

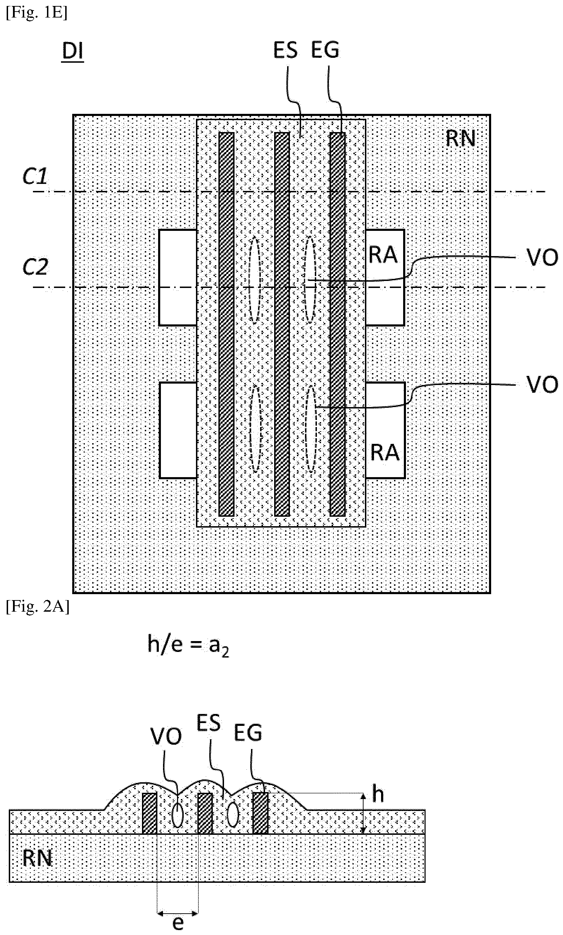

Un premier aspect de l'invention illustré aux [Fig. 1A] à [Fig. 1E] concerne un dispositif DI semi-conducteur réalisé sur un substrat comprenant au moins une région active RA et une région non-active RA entourant au moins partiellement la région active RA. Comme illustré à la [Fig. 1E], lorsque plusieurs régions actives RA sont présentes, alors la région non-active RN entoure au moins partiellement lesdites régions actives RA.

On entend par région active RA une région qui comprend une couche de matériau semi-conducteur, par exemple du silicium, susceptible de former, avec les empilements de grille EG, un canal ainsi que les sources et drains de transistor. On entend par région non-active RN une région qui ne comprend pas de matériau semi-conducteur susceptible de former, avec les empilements de grille EG, un canal de transistor. Une région non-active RN (aussi appelée zone d'isolation) peut par exemple être constituée ou comprendre une STI (pour Shallow Trench Isolation en anglais - élément bien connu du domaine). Dans un mode de réalisation, le substrat est un substrat de type SOI. De préférence, la région active RA est alors formée par une couche de silicium et la région non-active RN est alors formée par une STI sur SOI.

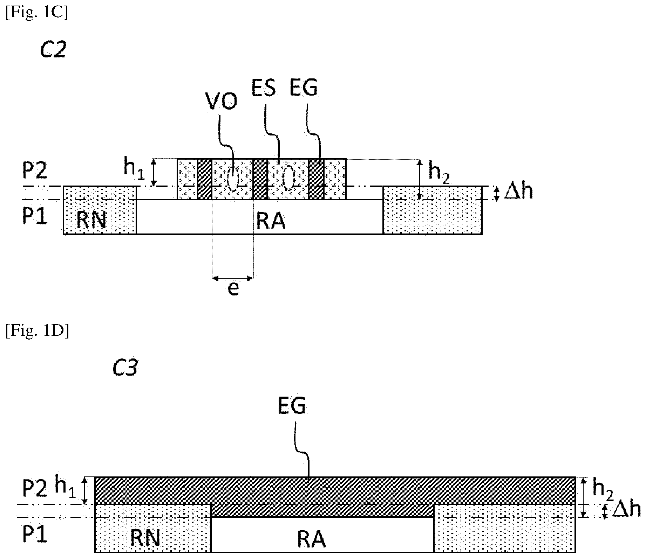

De plus, comme illustré à la [Fig. 1A], le dispositif DI selon l'invention comprend une pluralité d'empilements de grille EG, chaque empilement de grille EG de la pluralité d'empilements de grille EG étant parallèle aux autres empilements de grille EG de la pluralité d'empilements de grille EG. De plus, comme illustré aux [Fig. 1B] et [Fig. 1C] (qui représentent le dispositif DI selon la coupe C1 et la coupe C2 respectivement), chaque empilement de grille EG est séparé des empilements de grille EG adjacents d'une distance égale à e au moyen d'un espaceur ES. En général, comme illustré à la [Fig. 1B], un empilement de grille EG comprend un oxyde de grille OG (par exemple de l'oxyde de silicium), une couche de métal ME sur l'oxyde de grille OG (par exemple du nitrure de titane) et une couche de polysilicium PS sur la couche de métal ME. D'autres configurations peuvent cependant être envisagées.

En outre, comme illustré aux [Fig. 1A] à [Fig. 1C], chaque empilement de grille EG est disposé de sorte qu'une partie de l'empilement EG considéré est sur la région active RA. Il s'en suit que chaque empilement de grille EG est également disposé de sorte qu'une partie de l'empilement de grille EG considéré est sur la région non-active RN.

De plus, comme illustré à la [Fig. 1D] qui représente une vue du dispositif selon la coupe C3, pour chaque empilement de grille EG, la partie de l'empilement de grille EG considéré située sur la région non-active RN à une première hauteur h₁ et la partie EG de l'empilement de grille considéré située sur la région active RA à une deuxième hauteur h₂, la deuxième hauteur h₂ étant supérieure à la première hauteur h₁. Dans la suite, la différence entre la deuxième hauteur h₂ et la première hauteur h₁ sera noté Δh. Dans un mode de réalisation préférentiel, la surface de la région active RA est située dans un premier plan P1 et la surface de la région non-active RN est situé dans un deuxième plan P2, le premier plan P1 étant située à une hauteur inférieure de Δh à celle du deuxième plan P2

En outre, dans le dispositif DI selon l'invention, pour chaque empilement de grille EG de la pluralité d'empilements de grille EG, la hauteur h₂ de la partie d'empilement de grille EG située sur la région active RA et la hauteur h₁ de la partie du même empilement de grille EG située sur la région non-active RA vérifient les relations h₂/e = a₂ et h₁/e = a₁ où a₂ est un rapport d'aspect tel que, lors de la croissance du matériau espaceur formant les espaceurs ES, une zone d'air est dans ledit espaceur ES, et a₁ est un rapport d'aspect tel que, lors de la croissance du matériau espaceur formant les espaceurs ES, aucune zone d'air n'est dans ledit espaceur ES.

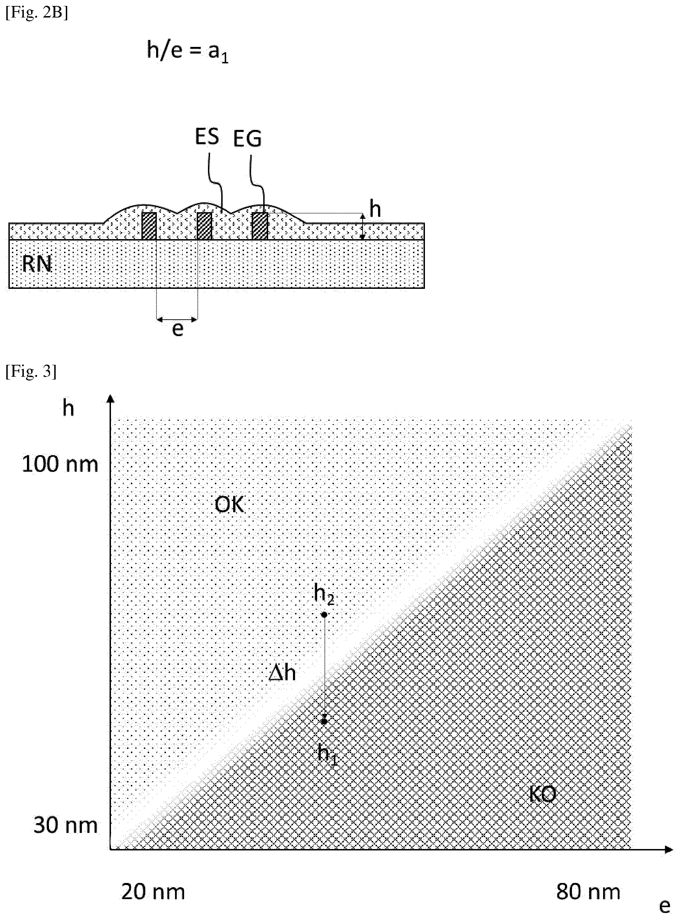

La notion de rapport d'aspect limite est illustrée à la [Fig. 2A] et à la [Fig. 2B]. La structure représentée à la [Fig. 2A] présente un rapport d'aspect h/e égal au rapport d'aspect a₂ et une zone d'air VO se forme donc dans les espaceurs ES. A contrario, la structure représentée à la [Fig. 2B] présente un rapport d'aspect h/e égal au rapport d'aspect a₁ et aucune zone d'air VO ne se forme donc dans les espaceurs ES. Ainsi, dans le dispositif DI selon l'invention, chaque espaceur ES séparant un empilement de grille EG du suivant comporte, au niveau de la région active RA, une zone d'air VO.

Les rapports d'aspect a₁ et a₂ peuvent être aisément déterminés de manière expérimentale en déposant le matériau utilisé pour former les espaceurs ES avec différentes valeurs du rapport d'aspect et en relevant pour quelles valeurs du rapport d'aspect une zone d'air VO est formée lors dudit dépôt. Un graphique illustrant une telle détermination est illustré à la [Fig. 3]. Sur cette figure, les couples de valeurs (e, h) correspondant à des points situés dans la zone supérieure OK permettent la formation d'une zone d'air VO. Aussi, a₂ pourra être choisi parmi tous les rapports d'aspect associés aux couples (h,e) situés cette zone supérieur OK. A contrario, les couples de valeurs (e, h) correspondant à des points situés dans la zone inférieure KO ne permettent pas la formation d'une zone d'air VO. Aussi, a₁ pourra être choisi parmi tous les rapports d'aspect associés aux couples (h,e) situés cette zone inférieure KO. Ainsi, le couple (e, h₂) correspond à un point se situant dans la zone supérieure OK alors que le couple (e, h₁) correspond à un point se situant dans la zone inférieure KO. Dans un mode de réalisation, le rapport d'aspect a₂ est égal à 1.5 et/ou le rapport d'aspect a₁ est égal à 1. Dans un mode de réalisation a₂ ≥ 1.5 et a₁ ≤ 1, voire a₂ ≥ 1.5 et a₁ ≤ 0.9.

Dans un mode de réalisation, la hauteur h₁ est comprise entre 30 et 50 nm (bornes incluses). Dans un mode de réalisation, la hauteur h₂ est comprise entre 60 et 100 nm (bornes incluses). Dans un mode de réalisation, la distance e séparant deux empilements de grilles EG successifs est comprise entre 20 et 40 nm (bornes incluses).

Dans un mode de réalisation, chaque empilement de grille EG a une largeur (mesurée selon le même sens que la distance e) comprise entre 10 et 40 nm (bornes incluses).

Dans un mode de réalisation, les espaceurs ES sont formés par une couche de matériau espaceur, par exemple du nitrure, ayant une épaisseur t supérieure ou égale à 0.3×e, de préférence supérieure ou égale à 0.4×e, voire supérieure ou égale à 0.5×e. On s'assure ainsi que suffisamment de matériau espaceur est déposé pour former un espaceur ES comprenant une zone d'air VO. Dans un mode de réalisation, l'épaisseur t de la couche de matériau espaceur est comprise entre 15 et 20 nm (borne incluses).

Dans un exemple de réalisation, l'épaisseur de la couche de matériau espaceur est comprise entre 15 et 20 nm (bornes incluses), la distance e séparant deux empilements de grille successif est comprise entre 20 et 30 nm (bornes incluses), la hauteur h₂ est comprise entre 60 et 80 nm et la hauteur h₁ est comprise entre 30 et 40 nm. Dans un mode de réalisation, le matériau espaceur est un nitrure, de préférence un nitrure de silicium.

### Premier procédé de fabrication

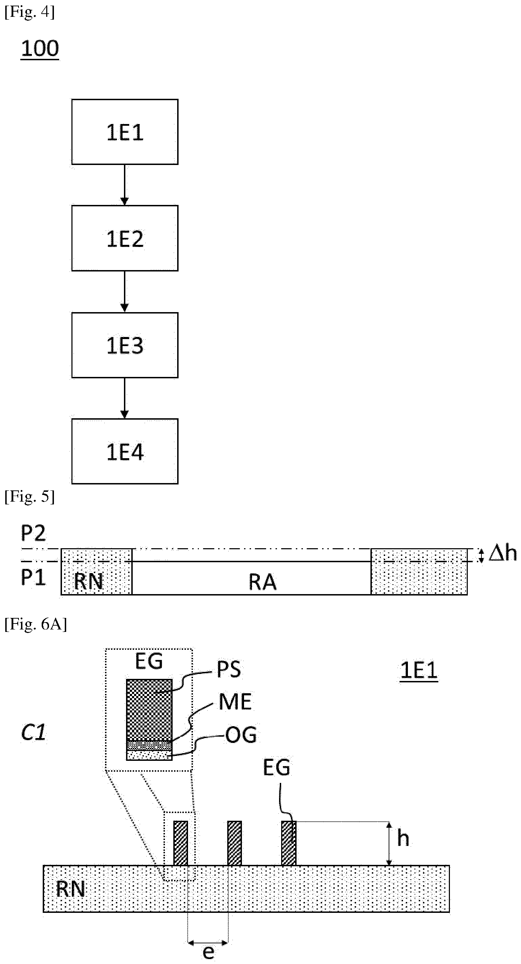

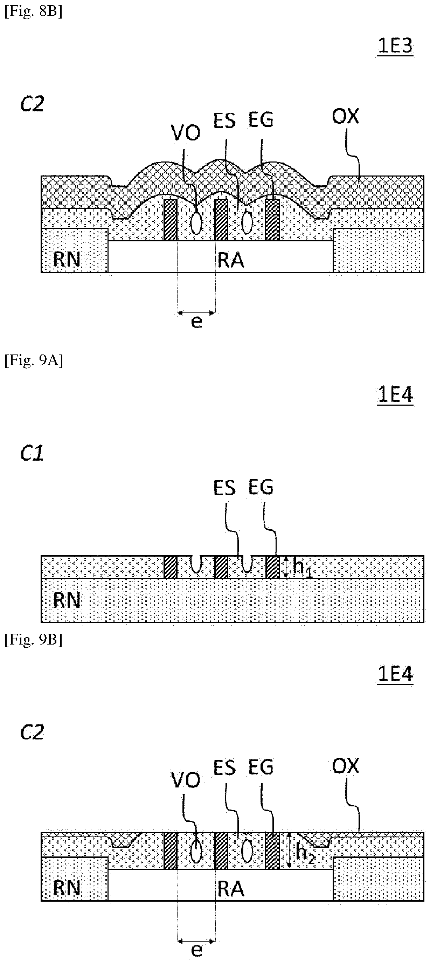

Un deuxième aspect de l'invention illustré aux [Fig. 4] à [Fig. 9B] concerne un procédé 100 de fabrication d'un dispositif DI semiconducteur à partir d'un substrat (illustré à la [Fig. 5]), de préférence un substrat de type SOI, comportant au moins une région active RA et une région non-active RN entourant au moins partiellement la région active RA. De plus, la surface de la région active RA est située dans un premier plan P1 et la surface de la région non-active est située dans un deuxième plan P2, le premier plan P1 étant située à une hauteur inférieure à celle du deuxième plan P2. Comme illustré à la [Fig. 5], la différence de hauteur entre le premier plan P1 et le deuxième plan P2 est notée Δh dans la suite.

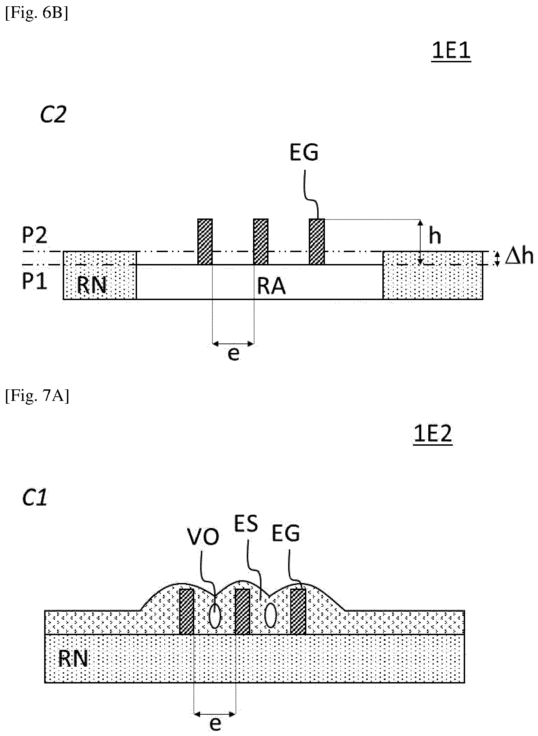

Comme illustré aux [Fig. 6A] et [Fig. 6B], le procédé 100 comprend une étape 1E1 de formation d'une pluralité d'empilements de grille EG parallèles les uns aux autres, chaque empilement de grille EG ayant une hauteur h (supérieure à la hauteur h₂ introduite plus loin) et étant séparé du ou des empilements de grille EG les plus proches par une distance e.

En général, comme illustré à la [Fig. 6A], un empilement de grille EG comprend un oxyde de grille OG (par exemple de l'oxyde de silicium), une couche de métal ME sur l'oxyde de grille OG (par exemple du nitrure de titane) et une couche de polysilicium PS sur la couche de métal ME. Aussi, la pluralité d'empilements de grille EG peut par exemple être obtenue par le dépôt des différentes couches formant un empilement de grille EG, lesdites couches étant ensuite gravées de sorte à obtenir la pluralité d'empilements de grille EG. S'agissant d'étapes bien connues dans le domaine, elles ne sont pas détaillées dans la suite.

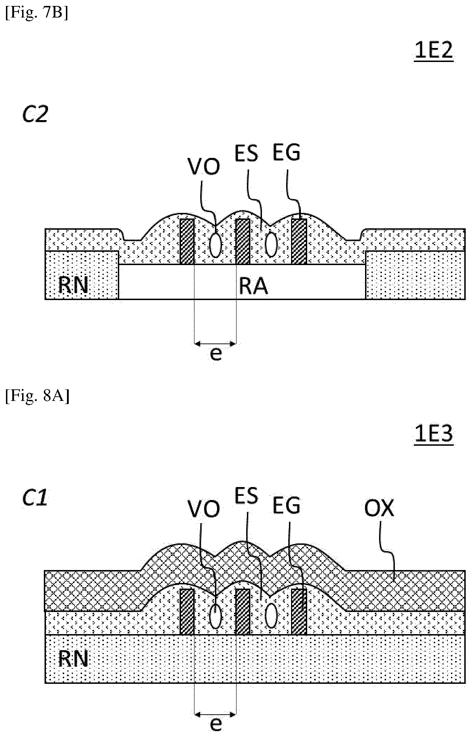

Comme illustré aux [Fig. 7A] et [Fig. 7B], le procédé 100 comprend ensuite une étape 1 E2 de dépôt d'une couche d'un matériau espaceur, par exemple du nitrure, de sorte à former un espaceur ES entre chaque empilement de grille ES, l'épaisseur t de la couche déposée étant, de préférence, supérieure ou égale à 0.3xe. De plus, la hauteur h des empilements de grille EG lors de cette étape 1E2 est telle que h/e ≥ a₂ où a₂ est le rapport d'aspect introduit précédemment permettant la formation de zones d'air VO. Aussi, il se forme, lors du dépôt de la couche d'un matériau espaceur, une zone d'air VO au sein des espaceurs ES entre chaque empilement de grille EG.

Comme illustré aux [Fig. 8A] et [Fig. 8B], le procédé comprend également une étape 1E3 de dépôt d'une couche d'un matériau diélectrique OX.

Comme illustré aux [Fig. 9A] et [Fig. 9B], le procédé 100 comprend en outre une étape 1E4 de polissage mécanochimique de sorte que, à l'issue de cette étape 1E4, la partie des empilements de grille située sur la région active a une hauteur h₂ choisie de sorte que h₂/e = a₂. De préférence, cette étape est réalisée en deux sous-étape : une première sous-étape de polissage mécanochimique de sorte à niveler la couche de matériau diélectrique OX puis une deuxième sous-étape de polissage mécano-chimique de sorte à venir exposer le sommet des empilements de grilles EG. L'obtention d'une hauteur h₂ au niveau de la partie des empilements de grille EG située sur la région active RA suppose, compte tenu de la différence de hauteur entre la région active RA et la région non-active RN, que la partie des empilements de grille EG au niveau de la région non-active RN a une hauteur h₂- Δh=h₁. En outre, Δh est choisi de sorte que h₁/e = a₁ où a₁ est le rapport d'aspect introduit précédemment et ne permettant pas la formation de zones d'air VO.

Aussi, l'étape 1E4 de polissage-mécanochimique est mise en oeuvre de sorte que les zones d'air VO formées dans les espaceurs ES au niveau de la région non-active se retrouve exposés (cf. [Fig. 9A]) tandis que celles formées dans les espaceurs ES au niveau de la région active RA demeurent (cf. [Fig. 9B] - autrement dit, ne sont pas exposées).

Dans un mode de réalisation, le procédé 100 comprend ensuite une étape de dépôt d'une couche de matériau de sorte à combler les zones d'air VO ainsi exposées. Il peut s'agir d'un dépôt d'une couche de passivation.

A l'issue de ce procédé 100 un dispositif selon l'invention est obtenu.

### Deuxième procédé de fabrication

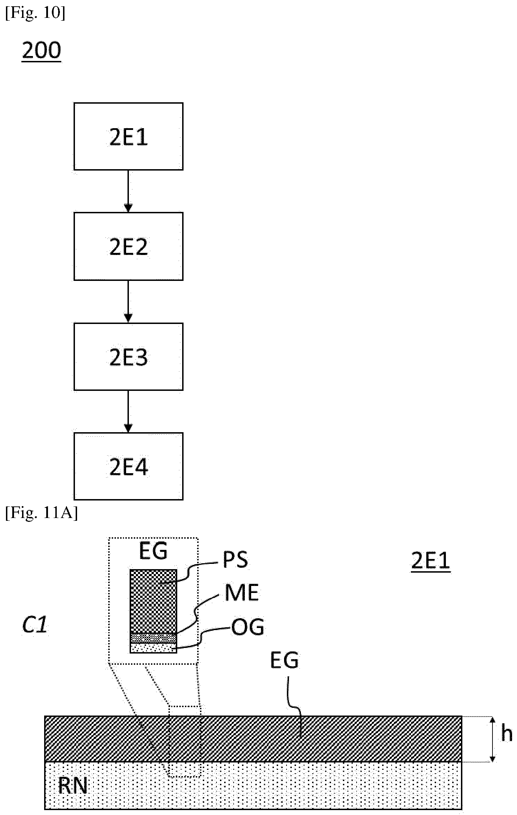

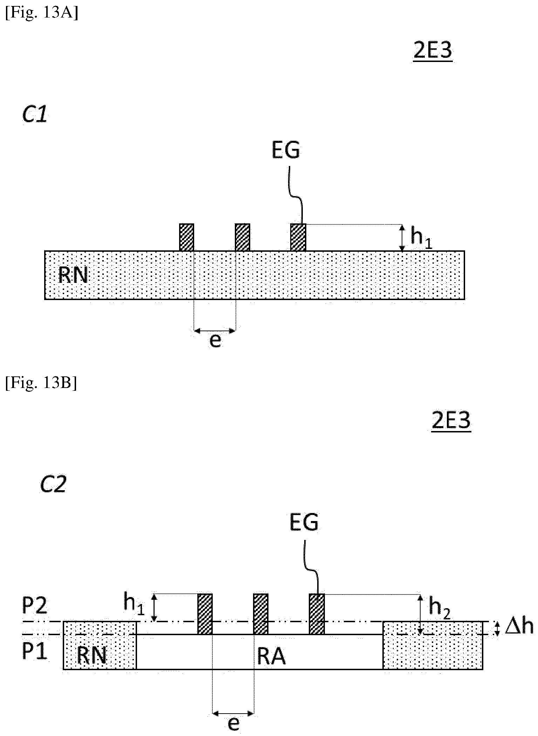

Un troisième aspect de l'invention illustré aux [Fig. 10] à [Fig. 13B] concerne un procédé 200 de fabrication d'un dispositif DI semiconducteur à partir d'un substrat (illustré à la [Fig. 4]) comportant au moins une région active RA et une région non-active RA entourant au moins partiellement la région active RA. Dans le procédé 200 selon un troisième aspect de l'invention (comme précédemment), la surface de la région active RA est située dans un premier plan P1 et la surface de la région non- RN est située dans un deuxième plan P2, le premier plan P1 étant située à une hauteur inférieure à celle du deuxième plan P2. De plus, comme illustré à la [Fig. 4], la différence de hauteur entre le premier plan P1 et le deuxième plan P2 est notée Δh dans la suite.

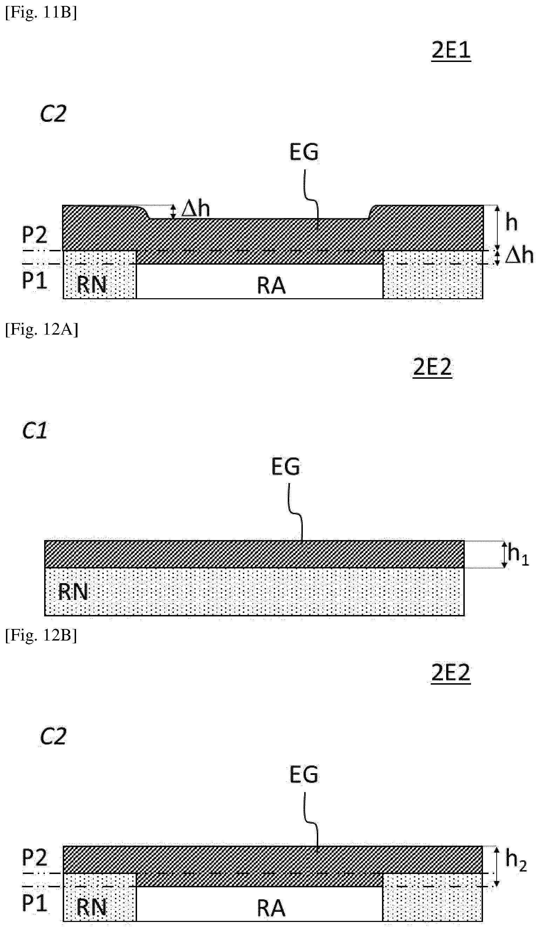

Comme illustré aux [Fig. 11A] et [Fig. 11B], le procédé 200 comprend une étape 2E1 de dépôt pleine plaque d'une couche d'empilements de grille EG. Dans un mode de réalisation, la couche d'empilement de grille comprend un oxyde de grille OG (par exemple de l'oxyde de silicium), une couche de métal ME sur l'oxyde de grille OG (par exemple du nitrure de titane) et une couche de polysilicium PS sur la couche de métal ME.

Comme illustré aux [Fig. 12A] et [Fig. 12B], le procédé 200 comprend une étape 2E2 de polissage-mécanochimique de sorte que la couche d'empilements de grille EG située sur la région active RA a, à l'issue de cette étape 2E2, une épaisseur h₂. L'obtention d'une épaisseur h₂ suppose, compte tenu de la différence de hauteur entre la région active RA et la région non-active RN, que la couche d'empilements de grille EG au niveau de la région non-active RN a une épaisseur h₂-Δh=h₁.

Comme illustré aux [Fig. 13A] et [Fig. 13B], le procédé 200 comprend une étape 2E3 de formation, à partir de la couche d'empilement de grille EG, d'une pluralité d'empilements de grille EG parallèles les uns aux autres, chaque empilement de grille EG étant séparé du ou des empilements de grille EG les plus proches par une distance e. Ainsi, la partie des empilements de grille située dans la région active RA à une hauteur h₂ tandis que la partie des empilements de grille située dans la région non active RN à une hauteur h₁=h₂-Δh. Par ailleurs, h₂ est choisie de sorte que h₂/e = a₂ et Δh est choisi de sorte que h₁/e = a₁ où a₂ est un rapport d'aspect tel que, lors de la croissance du matériau espaceur formant les espaceurs ES, une zone d'air VO se forme au sein dudit espaceur ES, et a₁ est un rapport d'aspect tel que, lors de la croissance du matériau espaceur formant les espaceurs ES, aucune zone d'air VO ne se forme au sein dudit espaceur ES.

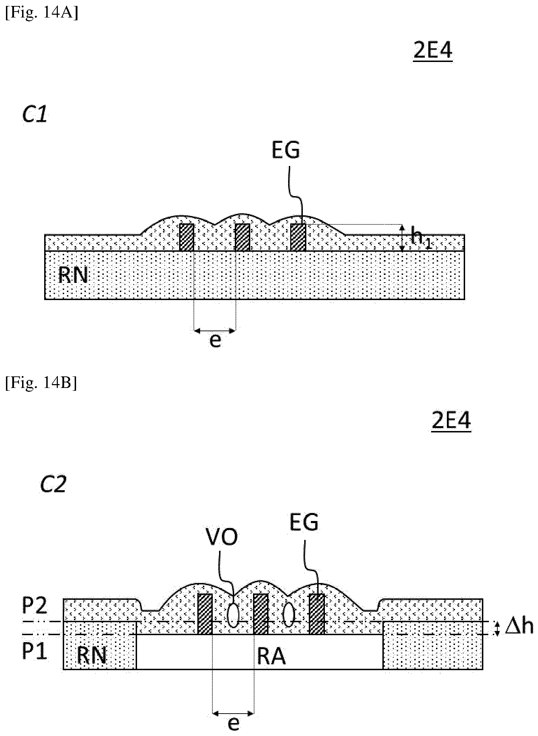

Comme illustré aux [Fig. 14A] et [Fig. 14B], le procédé comprend une étape 2E4 de dépôt d'une couche d'un matériau espaceur, par exemple en nitrure, de sorte à former un espaceur ES entre chaque empilement de grille EG. L'épaisseur t de la couche déposée est de préférence supérieure ou égale à 0.3xe. En outre, cette étape de dépôt se faisant alors h₁/e = a₁ et h₂/e = a₂, une zone d'air VO est formée dans chaque espaceur au niveau de la partie située sur la région active RA.

A l'issue de ce procédé 200 également un dispositif selon l'invention est obtenu.

## Revendications

1. Dispositif (DI) semi-conducteur réalisé sur un substrat comprenant au moins une région active (RA) et une région non-active (RN) entourant au moins partiellement la région active (RA), une pluralité d'empilements de grille (EG), une partie de chaque empilement de grille (EG) de la pluralité d'empilements de grille (EG) étant sur la région active (RA) et une partie desdits empilements étant sur la région non active (RN), chaque empilement de grille (EG) étant séparé d'au moins un des empilements de grille (EG) adjacents au moyen d'un espaceur (ES) par une distance égale à e, le dispositif (DI) étant **caractérisé en ce que**, pour chaque empilement de grille (EG) de la pluralité d'empilements de grille (EG), la partie d'empilement de grille (EG) située sur la région active (RA) a une hauteur h₂, la partie du même empilement de grille (EG) située sur la région non-active (RN) a une hauteur h₁ et **en ce que** h₂/e =a₂ et h₁/e = a₁ où a₂ est un rapport d'aspect tel que, lors de la croissance du matériau espaceur formant les espaceurs (ES), une zone d'air est dans ledit espaceur (ES), et a₁ est un rapport d'aspect tel que, lors de la croissance du matériau espaceur formant les espaceurs (ES), aucune zone d'air n'est dans ledit espaceur (ES).

2. Dispositif (DI) selon la revendication précédente dans lequel la surface de la région active (RA) est située dans un premier plan (P1) et la surface de la région non-active est situé dans un deuxième plan (P2), le premier plan (P1) étant située à une hauteur inférieure à celle du deuxième plan (P2), la différence de hauteur Δh entre le premier plan (P1) et le deuxième plan (P2) étant égale à la différence entre la hauteur h₂ des empilements de grille (EG) sur la région active (RA) et la hauteur h₁ des empilement de grille (EG) sur la région non-active (RN).

3. Dispositif (DI) selon l'une des revendications précédentes dans lequel, les espaceurs (ES) sont formés par une couche de matériau espaceur ayant une épaisseur t supérieure ou égale 0.3×e.

4. Dispositif (DI) selon l'une des revendications précédentes comprenant une pluralité de régions actives (RA).

5. Dispositif (DI) selon l'une des revendications précédentes dans lequel a₂ ≥ 1.5 et a₁ ≤ 1.

6. Dispositif (DI) selon l'une des revendications précédentes dans lequel la hauteur h₁ est comprise entre 30 et 50 nm, la hauteur h₂ est comprise entre 60 et 100 nm et/ou la distance e séparant deux empilements de grilles (EG) successifs est comprise entre 20 et 40 nm.

7. Dispositif (DI) selon l'une des revendications précédentes dans lequel les espaceurs (ES) sont en nitrure.

8. Procédé (100) de fabrication d'un dispositif (DI) semiconducteur à partir d'un substrat comportant au moins une région active (RA) et une région non-active (RA) entourant au moins partiellement la région active (RA), la surface de la région active (RA) est située dans un premier plan (P1) et la surface de la région non-active est située dans un deuxième plan (P2), le premier plan (P1) étant située à une hauteur inférieure à celle du deuxième plan (P2), le procédé comprenant :
- une étape (1E1) de formation d'une pluralité d'empilements de grille (EG) parallèle les uns aux autres, chaque empilement de grille (EG) étant séparé du ou des empilements (EG) de grille les plus proches par une distance e ;
- une étape (1E2) de dépôt d'une couche d'un matériau espaceur de sorte à former un espaceur (ES) entre chaque empilement de grille ;
- une étape (1E3) de dépôt d'une couche d'un matériau diélectrique (OX) ;
- une étape (1E4) de polissage-mécanochimique de sorte que, à l'issue de cette étape (1E4), la partie des empilements de grille (EG) située sur la région active (RA) a une hauteur h₂ ;
la hauteur entre le premier plan (P1) et le deuxième plan (P2) étant égale Δh, la hauteur h₂, la différence de hauteur Δh et la distance e séparant deux empilements de grille (EG) étant choisis de sorte que h₂/e = a₂ et (h₂-Δh )/e = a₁ où a₂ est un rapport d'aspect tel que, lors de la croissance du matériau espaceur formant les espaceurs (ES), une zone d'air se forme au sein dudit espaceur (ES), et a₁ est un rapport d'aspect tel que, lors de la croissance du matériau espaceur formant les espaceurs (ES), aucune zone d'air ne se forme au sein dudit espaceur (ES).

9. Procédé selon la revendication précédente dans lequel l'étape (1E4) de polissage mécanochimique comprend :
- une première sous-étape de polissage mécanochimique de sorte à niveler la couche de matériau diélectrique (OX) ;
- une deuxième sous-étape de polissage mécano-chimique de sorte que, à l'issue de cette sous-étape, la partie des empilements de grille (EG) située sur la région active (RA) a une hauteur h₂.

10. Procédé (200) de fabrication d'un dispositif (DI) semiconducteur à partir d'un substrat comportant au moins une région active (RA) et une région non-active (RA) entourant au moins partiellement la région active (RA), la surface de la région active (RA) est située dans un premier plan (P1) et la surface de la région non-active est situé dans un deuxième plan (P2), le premier plan (P1) étant située à une hauteur inférieure à celle du deuxième plan (P2), le procédé comprenant :
- une étape (2E1) de dépôt pleine plaque d'une couche d'empilement de grille (EG) ;
- une étape (2E2) de polissage-mécanochimique de sorte que la couche d'empilements de grille (EG) située sur la région active (RA) à l'issue de cette étape (2E2) a une épaisseur h₂ ;
- une étape (2E3) de formation, à partir de la couche d'empilement de grille, d'une pluralité d'empilements de grille (EG) parallèles les uns aux autres, chaque empilement de grille (EG) étant séparé du ou des empilements de grille (EG) les plus proches par une distance e ;
- une étape (2E4) de dépôt d'une couche d'un matériau espaceur de sorte à former un espaceur (ES) entre chaque empilement de grille (EG) ;
la différence de hauteur entre le premier plan (P1) et le deuxième plan (P2) étant égale Δh, l'épaisseur h₂, la différence de hauteur Δh et la distance e séparant deux empilements de grille (EG) étant choisis de sorte que h₂/e = a₂ et (h₂-Δh )/e = a₁ où a₂ est un rapport d'aspect tel que, lors de la croissance du matériau espaceur formant les espaceurs (ES), une zone d'air se forme au sein dudit espaceur (ES), et a₁ est un rapport d'aspect tel que, lors de la croissance du matériau espaceur formant les espaceurs (ES), aucune zone d'air ne se forme au sein dudit espaceur (ES).

11. Procédé (100, 200) selon l'une des deux revendications précédentes dans lequel le matériau espaceur est le nitrure de silicium.

12. Procédé (100, 200) selon l'une des trois revendications précédentes dans lequel une épaisseur t de matériau espaceur telle que t ≥ 0.3×e est déposée lors de l'étape de dépôt d'une couche d'un matériau espaceur.

13. Procédé selon l'une des cinq revendications précédentes dans lequel a₂ ≥ 1.5 et ai ≤ 1.

14. Procédé selon l'une des six revendications précédentes dans lequel l'étape de dépôt du matériau espaceur est réalisé par un dépôt chimique en phase vapeur assisté par plasma, un dépôt chimique en phase vapeur à basse pression ou un dépôt chimique en phase vapeur à pression sous-atmosphérique.
